# EUROPEAN PATENT SPECIFICATION

(11) **EP 2 712 082 B1**
(45) Date of publication and mention of the grant of the patent: **07.01.2015**
(21) Application number: 12185375.8
(22) Date of filing: 21.09.2012
(51) Int. Cl.: H03K 17/0412, H03K 17/0416, H03K 17/61, H03K 17/691

(54) **Power switch circuit with planar transformer drive**
Leistungsschalterkreis mit planarem Transformatorantrieb
Circuit de commutation de puissance avec commande de transformateur planaire

(43) Date of publication of application: 26.03.2014
(73) Proprietor: Ferroamp Elektronik AB, 163 53 Spånga (SE)
(72) Inventor: Jernström, Björn, 175 68 Järfälla (SE)
(74) Representative: Ebbinghaus, Johan Olof

(56) References cited:
- EP-A1- 2 242 067
- JP-A- 61 035 616
- JP-A- 61 224 725
- US-A- 3 805 094
- HUI S Y R ET AL: "Coreless PCB-based transformers for power MOSFET/IGBT gate drive circuits", POWER ELECTRONICS SPECIALISTS CONFERENCE, 1997. PESC '97 RECORD., 28TH ANNUAL IEEE ST. LOUIS, MO, USA 22-27 JUNE 1997, NEW YORK, NY, USA,IEEE, US, vol. 2, 22 June 1997 (1997-06-22), pages 1171-1176, XP010241696, DOI: 10.1109/PESC.1997.616896 ISBN: 978-0-7803-3840-1

## Description

### Technical field

The invention relates to a power switching circuit with a planar transformer drive and a machine or device comprising such a circuit. Further, it also relates to a method for driving a control gate of a power switch.

### Background Art

### Introduction

In modern power electronics such as motor drives, solar inverters, induction cooking equipment etc, power transistors such as IGBTs or MOSFETs are used to control the flow of electric power.

These power transistors requires a gate drive circuit to interface the logic circuitry to the power transistor. The gate drive circuit should provide electrical isolation between the logic circuit and the power transistor, it should also provide sufficient output current (0.5 - 5 A) in order to turn the transistor on fast enough.

Driving a power transistor involves, in the case of high impedance gate transistors, such as MOSFETs or IGBTs, supplying sufficient power to charge/discharge the transistor gate capacitance and to provide on/off signals to switch the transistor at the correct times.

For the case of power semiconductors with a low gate impedance, such as Thyristors and Triacs, they are current controlled and are turned on with a current pulse. Triacs and Thyristors do not have to be turned off; they turn themselves off when the controlled current goes to zero.

Traditionally gate drive circuits have been implemented by one of the following techniques or a combination of these:

| | |
|---|---|
| Conventional transformer | Transfer of signal and/or power |
| Optocoupler | Transfer of signal only |
| Bootstrapping | Transfer of power only |
| DC/DC converter | Transfer of power only |

In order to increase the switching frequency and reduce the costs for the gate drive circuit some new techniques using planar (PCB) transformers have been proposed:
Direct gate drive Transfer of signal and power
Modulated gate drive Transfer of signal and power

### Problems with prior art solutions

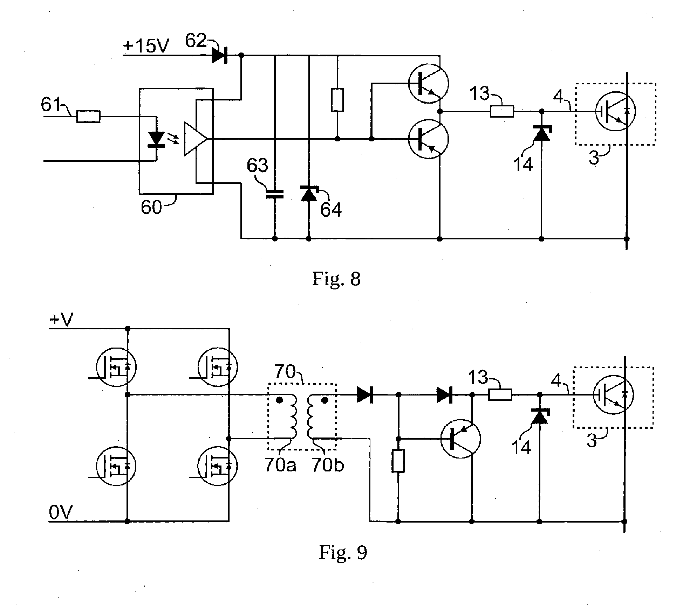

The prior art solutions using optocouplers (Figure 8) or conventional gate drive transformers suffer not only from the high costs of these components themselves but also from the cost of the required auxiliary components. (In figure 8, 60 denotes an optocoupler, 61 denotes a control signal, 62 denotes a bootstrap diode, 63 denotes a capacitor, and 64 denotes a Zener diode.)

A further drawback with the optocoupler solution is that it requires a floating power supply on the secondary side. This is usually accomplished by one or more DC/DC converters in combination with bootstrap circuits that all add cost and design complexity.

A further drawback of conventional gate drive transformers is the difficulty to design compact transformers with high isolation required for mains applications, but also from the low frequency limit making gate drive transformers impossible to use in many modern switching topologies. One example of this is the well-known NPC topology where some transistors are switched at mains frequency (50/60 Hz). While conventional gate drive transformers has a low frequency limit of about 1-10 kHz.

Some recent designs using planar (PCB; Printed Circuit Board) transformers solve some of these problems in the sense that a planar transformer implemented on a PCB is very low cost and provides very high isolation.

However, when using direct gate drive - where the signalling and power to turn on the power switch is transmitted together as the same signal waveform - the low frequency limit is some 100 - 1000 kHz due to the low inductance of practically sized planar transformers. Using a modulated gate drive, modulating the control signal onto the drive signal, solves the low frequency limit but instead adds expensive and complex auxiliary components for driving and demodulating the transformer signals. Figure 9 shows an example of a direct gate drive circuit.. 70 denotes a planar transformer in forward configuration with a primary winding 70a and a secondary winding 70b.

Both the direct gate drive and modulated gate drive using planar transformers are described in US 7 768 371 that proposes a gate drive using modulation keying. Similarly, R. T. Meitl (M.Sc. thesis North Carolina State University 2011) describes a direct gate drive circuit as well as a frequency modulated gate drive circuit using planar transformers.

JP 61 035616 A discloses a power switching circuit which corresponds to the preamble of claim 1.

Another problem with the prior art solutions using planar transformers is the limited coupling coefficient of planar transformers, that results in an output voltage of only 40 to 60% of the primary voltage for transformers with a 1:1 turns ratio. This is compensated for either by high primary voltages or voltage doubling circuits on the secondary side.

Another challenge when using planar (PCB) transformers is to contact the inner end of the windings while maintaining high isolation between primary and secondary side. When using a 2-layer PCB, jumpers are required. For 4-layer PCBs, via holes can be used to route the signal to another layer. However these via holes will have pads on both sides of the PCB and thus reduce the clearance between primary and secondary. One option to improve this, as suggested by Meitl in the prior art referenced above, is to use blind or buried vias. These will however significantly increase the PCB cost.

### Summary of Invention

### Technical problem

It is an object of the present invention to propose a solution for or a reduction of the problems of prior art. A main object is consequently to propose an improved power switching circuit with a planar transformer drive.

### Solution to Problem

According to the invention, this is accomplished by a power switching circuit according to claim 1.

This power switching circuit solves the above problems by implementing a gate drive circuit based on a planar transformer operated in flyback-mode.

This design requires a minimum of auxiliary components, thus significantly reducing the cost and complexity of the circuit.

A further advantage is that the circuit can easily be operated from different primary drive voltages and can thus make use of existing DC supplies in a design, without the need of voltage boost circuitry on the secondary side of the transformer.

Another advantage is that the output voltage can be significantly higher, even for a 1:1 turns ratio transformer, than the input voltage. This makes it possible to charge a gate to +15V from a +3.3V supply.

To turn the power switch off, one simple approach would be to use as power switch a power semiconductor such as a thyristor or triac that switches itself off when the current that it switches goes to zero.

A complementary circuit to turn the power switch off can also be implemented in many different ways within the scope of this invention. For instance, a drain circuit to turn off the power switch by draining charge from a gate capacitance of the power switch after a predetermined time would switch the power transistor off.

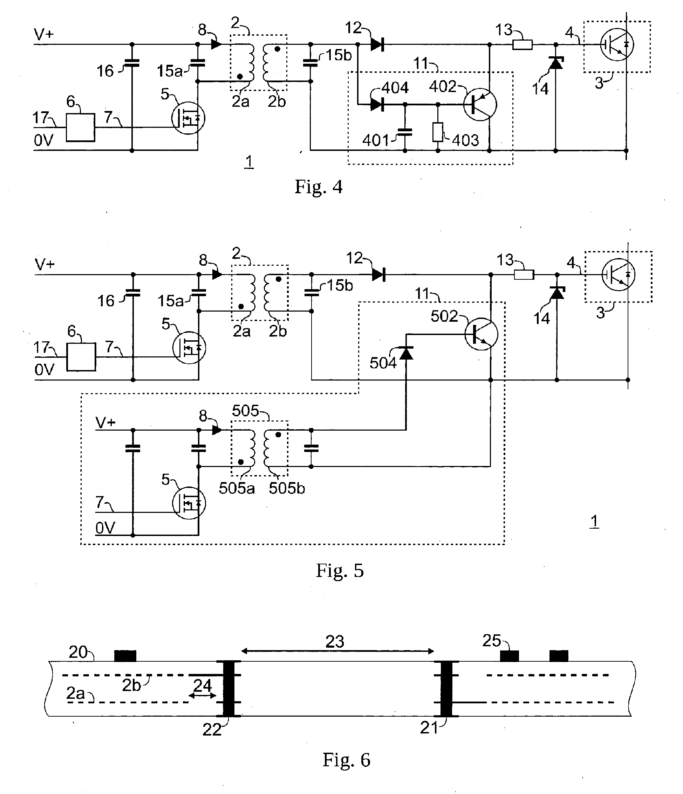

Another option is to implement a second planar transformer to send an off-command, see for instance fig. 5.

A further option is to implement a bidirectional flyback driver to get secondary (high voltage) flyback pulses of opposite polarity.

Since the gate drive circuitry of the power switching circuit only sends a pulse during turn-on or turn-off, the current consumption is zero when not switching the power transistor. This contributes to reduced power requirements from the control electronics and increased overall efficiency.

When very long pulse times are required, refresh pulses can be sent periodically to maintain the gate charge, when the power semiconductor is a voltage controlled device.

The planar transformer in this invention may be placed on the internal layers of a multi-layer PCB resulting in high clearance and creepage even with conventional vias.

Another advantage of placing the transformer windings in internal layers is that it frees up board space for components related to the gate drive circuitry that can be placed on top of the windings.

The power switching circuit is equally well adapted to drive both voltage controlled switches (MOSFETs, IGBTs) as current controlled power switches (Thyristors, Triacs, BJTs).

According to the invention, the problems of prior art are also solved or reduced according to the invention with a machine or device having the features of claim 14 and by a method having the features of claim 15. They bring advantages corresponding to those of the power switching circuit of the invention.

The dependent claims disclose further advantageous aspects of the invention.

### Brief Description of Drawings

Embodiments exemplifying the invention will now be described, by means of the appended drawings, on which:
Fig. 1 illustrates a basic circuit of the invention for turning the power switch on,
Fig. 2 illustrates current and voltage waveforms during turn-on of a current controlled power switch (low impedance switch such as a Thyristor, Triac, or BJT),
Fig. 3 illustrates current and voltage waveforms during turn-on of a voltage controlled switch (high impedance switch such as MOSFET, IGBT),
Fig. 4 illustrates a circuit according to the invention including one example of a turn-off circuit that will turn the power switch off after a predetermined time, refresh pulses can be sent to keep the power switch on,
Fig. 5 illustrates a circuit according to the invention including a second example of a turn-off circuit that will turn the power switch off by pulses from a second transformer,
Fig. 6 illustrates a cross section of a multi-layer PCB comprising a planar transformer according to the invention, having a primary winding 2a and secondary winding 2b, corresponding primary via 21 and secondary via 22,
Fig. 7a illustrates a winding of a planar transformer according to prior art, and
Fig. 7b illustrates a winding of an improved planar transformer of the invention,
Fig. 8 illustrates a prior art solution using an optocoupler, and
Fig. 9 illustrates a prior art solution using a planar transformer in a conventional forward configuration.

### Description of Embodiments

### Basic principle of the invention

The present invention uses a planar transformer in flyback-mode to turn on a power switch or power semiconductor. Both signal and power may be transmitted to the power switch, according to the principle of the invention.

The energy required to turn on the power semiconductor is first stored as a magnetic field in the planar transformer by building up a primary current. The primary current is then switched off and the stored energy in the transformer is dumped in the secondary side inducing an electrical pulse that reaches the gate of the power semiconductor, which thereby is turned on.

According to the present invention, this is achieved with a power switching circuit comprising the following basic components.

The power switching circuit according to the invention comprises a planar transformer having a primary winding and a secondary winding. The planar transformer may be realised on a printed circuit board (PCB for short) or on any other suitable substrate or surface. Further, it comprises a power switch that has a control gate that is in electrical connection with the secondary winding of the transformer. On the primary side of the planar transformer, there is a switching element (for instance an ordinary transistor of some sort) configured to provide switching on and off of an electrical current in the primary winding of the transformer.

Further, the circuit comprises a flyback switching circuitry that is configured to, in response to a control signal, send a turn-on electrical pulse to the power switch by controlling the switching element on the primary side to switch on, to build up a primary current in the primary winding, and then controlling the switching element to switch off. This dumps the energy stored in the transformer in the secondary winding, inducing the turn-on electrical pulse in the control gate to turn the power switch on. The flyback switching circuitry sends an output pulse with a predetermined pulse time in order to build up sufficient energy in the transformer to reliably turn on the selected power switch. Thus, it effectively turns the control signal into an on-pulse in the primary winding, the on-pulse having a correct pulse time.

With the power switching circuit of the invention it is possible to provide switching of the power switch with a frequency from DC to several MHz, thereby eliminating the low frequency limit of prior planar transformer power switching designs.

Also, the power switching circuit provides low frequency switching without modulation, eliminating expensive modulation circuits

As an example of a possible performance of a power switching circuit according to the invention, a typical implementation could use 200 - 300 ns to build up the magnetic field in the planar transformer and then about 100 ns to tear the magnetic field down. This would enable a typical implementation with a ∼ 2 MHz switching frequency.

When considering the switching speed for the power switching circuit of the invention, it could be realised that the energy transferred through the planar transformer must be enough to charge the power semiconductor gate capacitance (in case of a voltage controlled device). Then, the following formulas may be useful in designing a circuit:

The energy needed to load the gate capacitance of the power switch is:
- Egatecap ∼ 1/2 * Cge * U²
(Cge = capacitance gate-emitter, often ∼100pF -> 10nF. U= voltage to charge the gate with, typically 15V)

The energy stored in the transformer is:
- Etransf ∼ 1/2 * L * i²
(L = inductance primary winding
i maximum current through primary winding, dependent on length of drive pulse and primary voltage)

### Schematic circuit embodiment of the invention

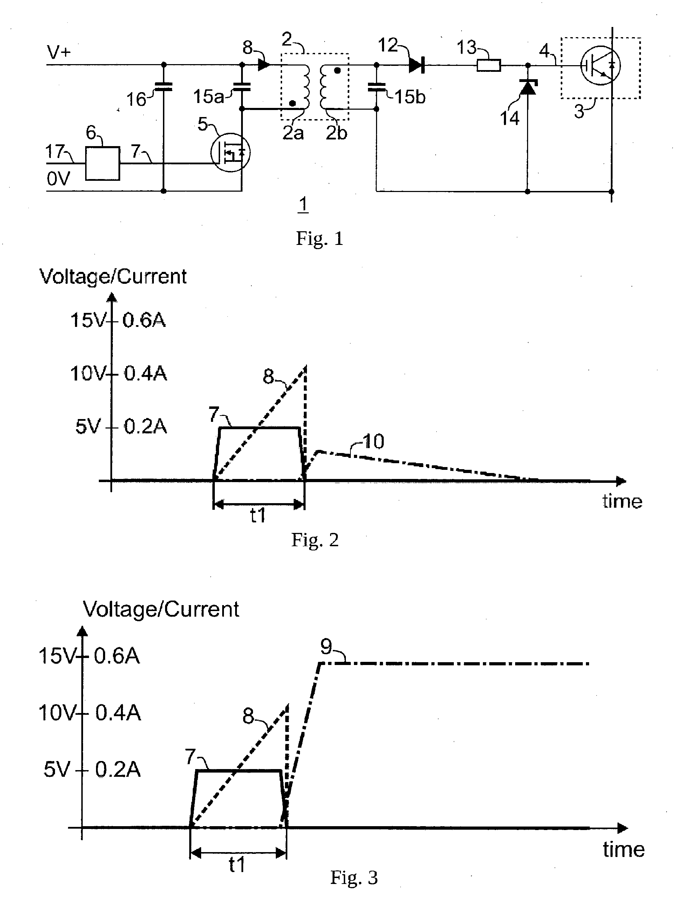

Fig. 1 illustrates an example of a schematic circuit embodiment of the power switching circuit 1 according to the invention for turning a power switch on.

In fig. 1, denoted with 2, is a planar transformer which can be implemented on a printed circuit board (PCB). It has a primary winding 2a and a secondary winding 2b. The gate 4 of the power switch 3 (in fig. 1, an IGBT power transistor), is in this embodiment in electrical connection with the secondary winding 2b via a diode 12 and a resistor 13. A zener diode 14 connects the gate 4 to the IGBT emitter. This zener diode 14 functions as an overvoltage protection and a voltage controller to control the voltage on the gate 4. It is an easy way to calibrate an incoming turn-on electrical pulse to the voltage requirements of a specific power semiconductor 3. The diode 12 serves to prevent a voltage on the gate capacitance of the gate 4 from discharging through the secondary winding 2b.

A switching element 5, in the form of a MOSFET transistor, is further provided in fig. 1. In this embodiment, it is connected in series with the primary winding 2a to allow it to provide switching on and off of an electrical current 8 in the primary winding 2a of the transformer 2. A capacitance 15a is provided in parallel with the primary winding 2a and likewise a capacitance 15b is provided in parallel with the secondary winding 2b. These capacitances serve to prevent electromagnetic compatibility (EMC) problems by preventing too quick/high voltage spikes during operation of the circuit and also improve circuit efficiency. The capacitor on the primary side also protects the switch transistor from too high flyback voltages when switching off. A further capacitance 16 is provided to quickly supply sufficient primary current.

Further, a flyback switching circuitry is provided indicated in the figure as a box denoted with the numeral 6. The flyback switching circuitry 6 is configured to, in response to a control signal 17 from some other entity, send a turn-on electrical pulse to the power switch 3 by controlling the switching element 5 to turn on and off to produce a flyback electrical pulse in the secondary winding. It does so in fig. 1 by applying a voltage 7 on the gate of the switching element to turn the switching element on and removing the voltage 7 on the gate to turn it off. For this purpose, the flyback switching circuitry could be based on any suitable circuit technology to produce the voltage signals and the timing of the voltage signals for the switching element. For instance, discrete circuits, lumped components or a computer processor could be used to accomplish this.

### Current controlled device

The workings and further embodiments of the power switching circuit will now be elucidated by means of fig. 2, which illustrates current and voltage waveforms during turn-on, when the power switch is a current controlled device (low impedance switch such as a Thyristor, Triac, BJT). These devices are ideally suited as the power switch of the switching circuit of the invention, since they do not need any turn-off signal; these types of semiconductors turn themselves off.

Such a power switching circuit, with a current controlled device, is not shown in any of the drawings, but can be conceptually thought of as the switching circuit in fig. 1 with the mosfet exchanged for, for instance, a Triac, Thyristor or BJT.

In this embodiment, when a control signal reaches the flyback switching circuitry, it starts to send the turn-on electrical signal to the power switch by first controlling the switching element to switch on, for instance by applying a voltage 7 on the gate of a transistor forming the switching element, allowing a current 8 to gradually build up in the primary winding of the planar transformer. Along with the current 8, a magnetic field around the windings of the transformer is also built up. Then, the flyback switching circuit controls the switching element to turn off, for instance by removing the voltage 7 on the gate of the transistor forming the switching element, whereupon the current 8 in the primary winding is also switched off, as seen at the end of the period t1 in fig. 2. The remaining magnetic field in the windings of the planar transformer then collapses, inducing a current 10 in the secondary winding.

Since the secondary winding is in electrical contact with the control gate of the power switch, this induced current reaches that control gate to turn the power switch on.

Since the power switch in this case comprises a low impedance gate, the gate current 10 can be seen to gradually decrease to zero. When the low impedance power switch is a Triac or a Thyristor, the power switch will continue to be switched on, even though the gate current has gone to zero, depending on the presence of a current switched by the power switch. If the power switch is a Bipolar junction transistor (BJT), it will turn off when the gate current 10, and therefore also the current through the gate of the BJT, has gone to zero. If it is desirable to keep a BJT on, this can be accomplished with successive turn-on electrical pulses such that the gate current 10 is not allowed to go to zero.

### Voltage controlled device

A further example of the workings of the power switching circuit will now be elucidated by means of fig. 3, which illustrates current and voltage waveforms during turn-on when the power switch of the power switching circuit is a voltage controlled device (high impedance switch such as a MOSFET, IGBT or JFET). Such a power switch is shown in the power switching circuit of fig. 1.

The characteristics of fig. 3 is quite similar to the characteristics described in conjunction with fig. 2: a control signal reaches the flyback switching circuitry, which then starts to send the turn-on electrical signal to the power switch by first controlling the switching element with a switching element control signal to switch it on and then off.

The gradual build up of the current 8 followed by the abrupt jump to zero of the current 8 at the end of the time interval t1 is the same as in fig. 2. However, the gate is in this case capacitively storing the voltage such that it remains elevated even after the magnetic field in the transformer has collapsed, as seen as the constant voltage 9 slightly after the end of the time interval t1 in fig. 3.

### Turn-off of the power switch

### Draining circuit

To turn the power switch of the switching circuit off (when it is a voltage controlled power switch), several different principles can be used.

A straightforward way would be to have the power switching circuit of the invention to further comprise a turn-off circuit 11 configured to turn the power switch off by draining charge from the power switch control gate after a predetermined time.

Such a power switching circuit with a drain circuit can be studied in fig. 4.

When a turn-on electrical pulse reaches the transistor 3, it also reaches the capacitor 401, charging it. As long as the charge in the capacitor 401 keeps the base of transistor 402 at approximately the same voltage as the emitter of transistor 402, and therefore also approximately the same voltage as on the gate 4 of the power transistor 3, the transistor 402 is not conducting and no current will float from the emitter to the collector. This will keep the power transistor 3 on, since the gate 4 will remain charged. The voltage on capacitor 401 drops through resistor 403 and when falling sufficiently below the voltage on the emitter of the transistor 402, it triggers the base on the transistor 402 to make the transistor 402 conducting such that the gate 4 of the power transistor 3 is discharged through the resistor 13 and through the transistor 402.

Thus, immediately following a turn-on electrical pulse to the power transistor 3, charging the capacitance of the gate 4 and the capacitor 401, the electrical charge in capacitor 401 starts to drain off through the resistor 403. When the voltage of the base is sufficiently below that of the emitter, the transistor 402 will turn on and start to drain charge from the base of the power transistor 3 through the resistor 13. Thereby the power transistor 3 will be turned off. The time to turn-off of the power transistor 3 from the time of the arrival of the turn-on electrical pulse will depend on the capacitance of the capacitor 401 and the resistance of the resistor 403. The resistance of the resistor 13 will decide the fall time of the power transistor 3 when the transistor 402 is turned on to drain the power transistor's 3 gate capacitance.

The diode 404 functions to let the turn-on electrical pulse into the turn-off circuit 11, but prevents the capacitor 401 to drain off through the secondary winding 2b when the planar transformer 2 no longer provides a voltage.

This is a simple construction where no signalling is needed. Of course, it would not be possible to have the power switch 3 turn off faster than a particular configuration of the turn-off circuit 11 allows.

If it is desired to keep the power switch 3 on longer than what is provided for by the drain circuit it is possible to send refresh pulses to the power switch before it turns off, to recharge the capacitor 401 to reset the turn-off period.

### Turn-off circuit responsive to a turn-off signal

Another example on how to accommodate turn off of the voltage controlled power switch would be to have the power switching circuit further comprise a turn-off circuit configured to drain charge from the power switch control gate in response to a turn-off signal, to turn the power switch off.

### Turn-off signal through planar transformer

For instance, the power switching circuit could comprise a turn-off circuit configured to receive the turn-off signal through the planar PCB transformer. The turn-off circuit could be configured to receive the turn-off signal as an electrical pulse of different duration than a turn-on electrical pulse. This would be advantageous in that it would be quite a simple driver circuit: only the timing signals from the flyback switching circuitry need to be modified for the signalling.

One example of a turn-off circuit to receive the turn-off signal could be one responsive to a turn-off signal in the form of an electrical pulse that is shorter than a turn-on electrical pulse. The power switching circuit could be calibrated such that these shorter drive pulses are not sufficiently longto turn the power transistor on. Such an arrangement could be implemented by transistors.

Other signalling schemes can of course be anticipated. For instance, the switching circuit could comprise a turn-off circuit that is configured to receive the turn-off signal as multiple consecutive electrical pulses, each having a different duration than a turn-on electrical pulse. This would entail modifying the timing of the signals from the flyback switching circuitry and a receiver circuit on the secondary side to receive the signals. As in the previous example such a receiver circuit can be built by transistors. This would still prove to be a relatively simple turn-off circuit that does not require too many components to realise.

Another variant of the turn-off circuit is to have it configured to receive the turn-off signal as an electrical pulse with reversed polarity compared to a turn-on electrical pulse. In this way, the receiver side could be simplified with the turn-off signal more or less directly depleting the charge on the gate of the power transistor. This advantage would come at the expense of a more complicated primary side, where there would have to be adjustments to allow a reverse polarity pulse to be sent, compared to a turn-on electrical pulse.

### Turn-off signal through second planar transformer

A further variant would be to have the power switching circuit with a turn-off circuit configured to receive the turn-off signal through a second planar PCB transformer.

An example of such a circuit is given in fig. 5. This figure builds on the embodiment with a turn-off circuit as in figure 4, but instead of the RC-circuit (formed by 401 and 403 in fig. 4) determining the turn-off time in relation to the turn-on electrical pulse, fig. 5 uses an extra planar transformer 505 to create a new channel that can be dedicated for turn-off signals to discharge the power transistor gate through transistor 502. Essentially, circuit 11 in fig. 5 is in-itself an embodiment of a switch circuit according to this invention controlling a current controlled device consisting of the BJT 502 in fig. 5.

### Refresh turn-on pulses

To maintain the power switch turned on for pulse times exceeding a gate leakage time of the charge controlled gate of the power transistor or the turn-off time controlled by a turn-off circuit, the flyback switching circuitry of any of the embodiments of the power switching circuit may be adapted to repeatedly send refresh turn-on electrical pulses. It may be noted that the leakage may be due to, for instance, an internal leakage of the gate of the power transistor or an external leakage due to an external circuit draining charge from the gate of the power transistor.

### Placement of any planar transformer

The placement of the windings of any planar transformer used in the power switching circuit of the invention can be improved as follows.

Both ends of each winding of a planar transformer must be contacted. Therefore, in addition to contacting the windings in the outer end, also the inner end in the centre of the windings must be contacted. Thus, this must be accomplished with a via, if any jumpers on the PCB should be avoided. This also leads to a need to use a multi layer PCB, since the contacting of a via with a PCB conductor trace needs to happen on a layer without any winding on it.

Since there are two windings for each transformer, two vias are needed; one via for the primary winding and one via for the secondary winding. The trouble begins when there is a need for a high isolation and a large creepage distance between the primary and secondary winding. (Typically 3 - 6 kV may be needed for circuits that are to be connected to a mains outlet). A high isolation and creepage distance may be needed when the transformer is in connection with a mains outlet.

Normal vias always penetrate completely through the substrate of the PCB, from one side to the other. To provide a certain creepage distance, each place where a via, connected to one of the windings, and the other winding are near each other, they have to be physically separated with the required creepage distance.

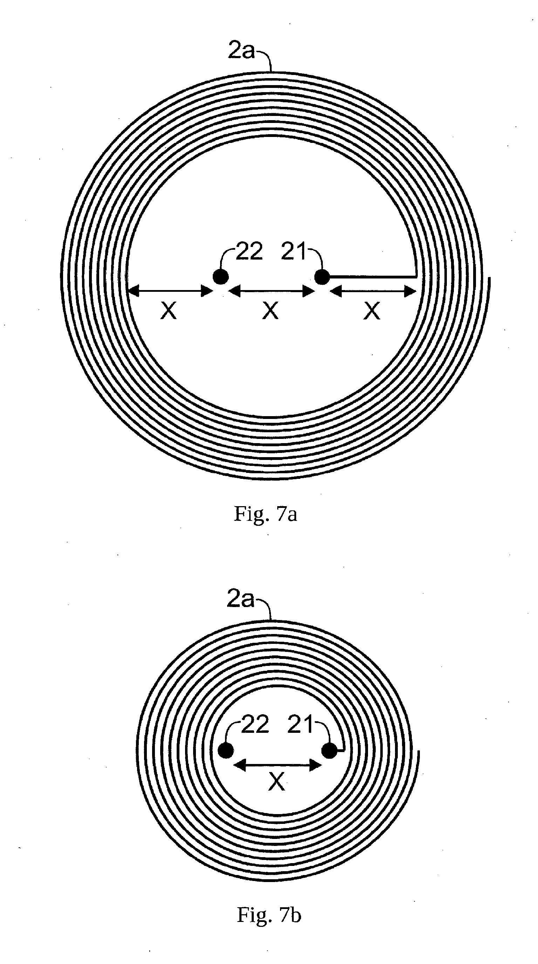

Thus, with the windings on each surface side of the substrate there must be, on the one side, a distance between the primary winding and the secondary via and, one the other side, a distance between the secondary winding and the primary via. In addition to this, there also need to be a distance between the vias themselves. These three requirements translates into a needed space in the centre of the windings of three times the required creepage distance, as illustrated in fig. 7a. Fig. 7a illustrates one winding of a planar transformer, a second winding of the planar transformer is located in another layer of a printed circuit board on which the planar transformer is realised. This second winding is not visible in fig. 7a.

In order to have windings with a smaller diameter, a way of getting around the above problem of having to have triple the creepage distance as the inner diameter, it is possible to use blind or buried vias as suggested by R. T. Meitl (M.Sc. thesis North Carolina State University 2011). In this way, the vias do not penetrate through the PCB substrate, but end in the inner layer(s) of the substrate where they contact a PCB conductor trace. Therefore, there is no outer end of a via of one winding that emerges on the side of the winding and consequently, the problem of small creepage distance between them does not occur.

However, blind vias are substantially more expensive to produce than normal vias. In order, therefore, to circumvent this, the following solution is suggested. The windings of any planar transformer of the power switching circuit can be situated on different internal layers of a multi-layer printed circuit board, each winding connected by a through hole via that is situated inside the windings of the planar PCB transformer and next to the inner periphery of said windings.

In this way, ordinary vias can be used which leads to lower cost PCB manufacturing. At the same time, the windings can be substantially smaller compared to a solution with ordinary vias and the windings on the surface layers, with a maintained creepage distance.

This will be further explained with reference to fig. 6, which illustrates a multi-layer circuit board 20. In the circuit board 20, there is a planar transformer having a primary winding 2a and a secondary winding 2b. The windings 2a, 2b are connected to a primary through via 21 and a secondary through via 22, respectively.

The vias 21, 22 are placed inside the planar transformer, that is, on the inside of the inner periphery of the windings 2a, 2b, as can be seen in fig. 6. The connection from a via to a winding can be seen in fig. 6 as a bold horizontal line from the via to the winding.

With this configuration, the isolation and the creepage distance between the windings can be substantially improved while still using ordinary vias. Also, this means that the windings can be made smaller for a given isolation and creepage rating compared to an arrangement where the windings are on the outer layers and are connected with through vias.

The reason for this is that the connection between the via and the winding is buried within the PCB substrate. The substrate provides a substantially higher isolation than air and no creepage distance is required in solid insulation. In fig. 6, the clearance between the primary winding 2a and secondary via 22 (and therefore also between the two windings at this point) is denoted with 24. This clearance can be much smaller than when the via and winding are exposed to each other with only air as isolator between them, due to the much higher isolation of the PCB substrate. The creepage distance will be the distance between the two vias in air, as denoted by 23 in fig. 6.

Fig. 7b illustrates this situation. This figure corresponds to fig. 6 seen from above. One of the windings is in this figure indicated with a continuous line but is in itself not visible from the outside, since it is buried inside the substrate. The other winding is situated on a different inner layer of the substrate below the first winding. Thus, the only visible parts from the outside are the two vias, seen as two dots in the figure. The creepage between the two windings is now the distance between the vias, which is called x in fig.7b.

Compare this with figure 7a, which illustrates a planar transformer where the windings are on the outer layers of a substrate. Thus, in this figure the windings are visible from the outside. Since each winding must have a creepage distance to the via of the other winding, there must be a space between each via and the other via's winding. For the same reason, there must also be a space between the vias themselves. Thus, in order to have a creepage distance between the windings in this configuration of x, there must be an inner space of the windings of three times x, as seen in fig. 7a. In figure 7b, only the creepage distance between the vias must be accounted for since there will not be any creepage between a via and another via's winding and therefore the inner diameter of the windings only have to be x, as seen in figure 7a.

Fig. 7b and as stated above, fig. 7a, only illustrates one of the windings of a planar transformer. The other winding is located on another layer of a printed circuit board. To achieve the best coupling factor, the two windings of the planar transformer would have the exact same number of turns and have the same diameter and would be situated exactly one above the other.

It should be noted that the described configuration of a planar transformer with improved creepage characteristics is usable with any planar transformer where these advantages are desirable. For instance with planar transformers 2 and 505 described earlier.

It should be further noted that this solution with the planar transformer located in different inner layers and connected with ordinary vias, as described above is also applicable for integration with devices and circuits other than the power switching circuit described herein. In that sense, the solution with the planar transformer stands on in its own feet.

### Modifications of the planar transformer

Any planar PCB transformer of the power switching circuit according to the invention could be formed as a coreless transformer with just the two windings isolated and aligned with each other. This is an easy and straightforward solution.

However, it is also possible that the power switching circuit according to any of the described embodiments could comprise a planar PCB transformer that comprises a ferromagnetic core. For instance, a small ferrite rod could be fixed in the middle of the windings. In this way, some improvement of the coupling between the windings may be achieved.

### Embodiments incorporating the power switching circuit

The power switching circuit according to any of the described embodiments can be integrated in any suitable machine or device. It will provide the benefit of a much simpler design; fewer components, leading to a lower cost, and also occupying less space on for instance a PCB where it is implemented.

### Method of the invention

The invention also comprises a method for driving a control gate of a power switch. The method comprises:
- using a planar transformer in flyback mode by
- storing energy, required to turn the power switch on, as a magnetic field in the transformer by building up a primary current in a primary winding of the planar PCB transformer,
- switching off the primary current, thereby dumping the energy stored in the transformer in a secondary winding of the transformer and
- energising the gate of the power switch with the energy dumped in the secondary winding, whereupon the gate is turned on.

The method entails advantages corresponding to those described in conjunction with the power switching circuit of the invention. Also, any embodiment of the power switching circuit described herein has a counterpart expressed in terms of the method of the invention.

For instance, the counterpart to the embodiment of the power switching circuit with a power switch being a current controlled device could be worded as follows:
The method further comprises that the steps are effected with the power switch being a current controlled device.

Similarly, any other embodiment of the power switching circuit could be expressed in terms of the method of the invention.

**Reference Signs List**

| | |
|---|---|
| 1. Power switching circuit | 20. Multi-layer circuit board |
| 2. Planar PCB transformer | 21. Primary via |
| 2a. Primary winding | 22. Secondary via |
| 2b. Secondary winding | 23. Primary to secondary creepage distance |
| 3. Power switch | 24. Internal primary to secondary clearance |
| 4. Control gate | 25. Surface mount components |
| 5. Switching element | 60. Optocoupler |
| 6. Flyback switching circuitry | 61. Control signal |
| 7. Switching element control signal | 62. Bootstrap diode |
| 8. Primary current | 63. Capacitor |
| 9. Gate voltage | 64. Zener diode |
| 10. Gate current | 70. Planar transformer in forward configuration |
| 11. Turn-off circuit | 70a. Primary winding |
| 12. Diode | 70b. Secondary winding |
| 13. Resistor | 401. Capacitance |
| 14. Zener diode | 402. Transistor |
| 15a. Primary winding capacitance | 403. Resistor |
| 15b. Secondary winding capacitance | 404. Zener-diode |
| 16. Capacitor | 502. Transistor |
| 17. Control signal | 504. Diode |
| 18. Turn-off circuit responsive to a turn-off signal | 505. Planar transformer |

## Claims

1. Power switching circuit (1), the circuit (1) comprising:
- a transformer (2) having a primary winding (2a) and a secondary winding (2b),
- a power switch (3) having a control gate (4) in electrical connection with the secondary winding (2b) of the transformer (2),
- a switching element (5) configured to provide switching on and off of an electrical current in the primary winding (2a) of the transformer (2), **characterised by**:
- the transformer (2) being a planar transformer,
- flyback switching circuitry (6) configured to, in response to a control signal (17), send a turn-on electrical pulse by:
- controlling the switching element (5) to switch on, to build up a primary current in the primary winding (2a), and then
- controlling the switching element (5) to switch off, to dump the energy stored in the transformer (2) in the secondary winding (2b) inducing the turn-on electrical pulse in the control gate (4) to turn the power switch (3) on.

2. Power switching circuit (1) according to claim 1, wherein the power switch (3) is a current controlled device.

3. Power switching circuit (1) according to claim 2, wherein the power switch (3) comprises any of: thyristor, triac, and BJT.

4. Power switching circuit (1) according to claim 1, wherein the power switch (3) is a voltage controlled device.

5. Power switching circuit (1) according to claim 4, wherein the power switch (3) comprises any of a MOSFET, IGBT, and JFET.

6. Power switching circuit (1) according to claim 4 or 5, further comprising a turn-off circuit (11) configured to turn the power switch (3) off by draining charge from the power switch control gate (4) after a predetermined time.

7. Power switching circuit (1) according to claim 4 or 5, further comprising a turn-off circuit (11) configured to drain charge from the power switch control gate (4) in response to a turn-off signal, to turn the power switch (3) off.

8. Power switching circuit (1) according to claim 7, wherein the turn-off circuit (11) is configured to receive the turn-off signal through the planar transformer (2).

9. Power switching circuit (1) according to claim 8, wherein the turn-off circuit (11) is configured to receive the turn-off signal as any of:
- an electrical pulse of different duration than a turn-on electrical pulse, or
- multiple consecutive electrical pulses, each having a different duration than a turn-on electrical pulse, or
- an electrical pulse with reversed polarity compared to a turn-on electrical pulse.

10. Power switching circuit (1) according to claim 7, wherein the turn-off circuit (11) is configured to receive the turn-off signal through a second planar transformer (505).

11. Power switching circuit (1) according to any of claims 1-10, wherein the flyback switching circuitry (6) is adapted to repeatedly send refresh turn-on electrical pulses.

12. Power switching circuit (1) according to any of claims 1-11, wherein the windings of any planar transformer (2; 505) are situated on different internal layers of a multi-layer printed circuit board (20), each winding connected by a through hole via (21, 22) that is situated inside the windings of the planar transformer (2; 505) and next to the inner periphery of said windings.

13. Power switching circuit (1) according to any of claims 1-12, wherein any planar transformer (2; 505) is a coreless transformer or comprises a ferromagnetic core.

14. Machine or device comprising a power switching circuit (1) according to any of previous claims.

15. Method for driving a control gate of a power switch, **characterised in** comprising:
- using a planar transformer in flyback mode by:
- storing energy, required to turn the power switch on, as a magnetic field in the transformer by building up a primary current in a primary winding of the planar transformer,
- switching off the primary current, thereby dumping the energy stored in the transformer in a secondary winding of the transformer and
- energising the gate of the power switch with the energy dumped in the secondary winding, whereupon the gate is turned on.

## Patentansprüche

1. Leistungsschalterkreis (1), wobei der Kreis (1) Folgendes umfasst:
- einen Transformator (2) mit einer Primärwicklung (2a) und einer Sekundärwicklung (2b),
- einen Leistungsschalter (3) mit einem Steuergate (4) in elektrischer Verbindung mit der Sekundärwicklung (2b) des Transformators (2),
- ein Schaltelement (5), das dafür ausgelegt ist, das Ein- und Ausschalten eines elektrischen Stroms in der Primärwicklung (2a) des Transformators (2) zu gewährleisten, **gekennzeichnet durch**:
- den Transformator (2), der ein planarer Transformator ist,
- eine Sperrwandlerschaltung (6), die dafür ausgelegt ist, in Reaktion auf ein Steuersignal (17) einen elektrischen Einschaltimpuls zu senden, wobei:
- das Schaltelement (5) derart gesteuert wird, dass es eingeschaltet wird, um einen Primärstrom in der Primärwicklung (2a) zu erzeugen, und wobei anschließend
- das Schaltelement (5) derart gesteuert wird, dass es ausgeschaltet wird, um die in dem Transformator (2) gespeicherte Energie in der Sekundärwicklung (2b) abzulegen, wobei der elektrische Einschaltimpuls im Steuergate (4) erzeugt wird, um den Leistungsschalter (3) einzuschalten.

2. Leistungsschalterkreis (1) nach Anspruch 1, wobei der Leistungsschalter (3) eine stromgesteuerte Vorrichtung ist.

3. Leistungsschalterkreis (1) nach Anspruch 2, wobei der Leistungsschalter (3) eines aus Folgendem umfasst: einen Thyristor, eine Zweirichtungs-Thyristortriode und einen Bipolartransistor.

4. Leistungsschalterkreis (1) nach Anspruch 1, wobei der Leistungsschalter (3) eine stromgesteuerte Vorrichtung ist.

5. Leistungsschalterkreis (1) nach Anspruch 4, wobei der Leistungsschalter (3) eines aus Folgendem umfasst: einen MOSFET, einen IGBT und einen JFET.

6. Leistungsschalterkreis (1) nach Anspruch 4 oder 5, ferner umfassend einen Löschkreis (11), der dafür ausgelegt ist, den Leistungsschalter (3) auszuschalten, indem nach einer vorbestimmten Zeit Ladung vom Steuergate (4) des Leistungsschalters abgezogen wird.

7. Leistungsschalterkreis (1) nach Anspruch 4 oder 5, ferner umfassend einen Löschkreis (11), der dafür ausgelegt ist, in Reaktion auf ein Abschaltsignal Ladung vom Steuergate (4) des Leistungsschalters abzuziehen, um den Leistungsschalter (3) auszuschalten.

8. Leistungsschalterkreis (1) nach Anspruch 7, wobei der Löschkreis (11) dafür ausgelegt ist, das Abschaltsignal durch den planaren Transformator (2) zu empfangen.

9. Leistungsschalterkreis (1) nach Anspruch 8, wobei der Löschkreis (11) dafür ausgelegt ist, das Abschaltsignal als eines von Folgendem zu empfangen:
- als einen elektrischen Impuls mit anderer Dauer als ein elektrischer Einschaltimpuls, oder
- als mehrere aufeinanderfolgende elektrische Impulse, wobei jeder eine andere Dauer als ein elektrischer Einschaltimpuls aufweist, oder
- als einen elektrischen Impuls mit im Vergleich zu einem elektrischen Einschaltimpuls umgekehrter Polarität.

10. Leistungsschalterkreis (1) nach Anspruch 7, wobei der Löschkreis (11) dafür ausgelegt ist, das Abschaltsignal durch einen zweiten planaren Transformator (505) zu empfangen.

11. Leistungsschalterkreis (1) nach einem der Ansprüche 1 bis 10, wobei die Sperrwandlerschaltung (6) dafür ausgelegt ist, auf wiederholte Weise elektrische Auffrischungs-Einschaltimpulse zu senden.

12. Leistungsschalterkreis (1) nach einem der Ansprüche 1 bis 11, wobei die Wicklungen jedes planaren Transformators (2; 505) auf unterschiedlichen inneren Schichten einer mehrschichtigen Leiterplatte (20) angeordnet sind, wobei jede Wicklung durch eine Durchkontaktierung (21, 22) angeschlossen ist, die in den Wicklungen des planaren Transformators (2; 505) und nahe des inneren Umfangs der Wicklungen angeordnet ist.

13. Leistungsschalterkreis (1) nach einem der Ansprüche 1 bis 12, wobei jeder planare Transformator (2; 505) ein kernloser Transformator ist oder einen ferromagnetischen Kern umfasst.

14. Maschine oder Vorrichtung, umfassend einen Leistungsschalterkreis (1) nach einem der vorhergehenden Ansprüche.

15. Verfahren zum Antrieb eines Steuergates eines Leistungsschalters, **dadurch gekennzeichnet, dass** es Folgendes umfasst:
- Verwenden eines planaren Transformator im Sperrwandlermodus, wobei:
- die zum Einschalten des Leistungsschalters benötigte Energie als Magnetfeld im Transformator gespeichert wird, indem ein Primärstrom in einer Primärwicklung des planaren Transformators aufgebaut wird,
- der Primärstrom abgeschaltet wird, wodurch die im Transformator gespeicherte Energie in einer Sekundärwicklung des Transformators abgelegt wird, und
- das Gate des Leistungsschalters mit der in der Sekundärwicklung abgelegten Energie gespeist wird, wodurch das Gate eingeschaltet wird.

## Revendications

1. Circuit de commutation de puissance (1), le circuit (1) comprenant :
- un transformateur (2) comportant un enroulement primaire (2a) et un enroulement secondaire (2b),
- un commutateur de puissance (3) comportant une grille de commande (4) connectée électriquement à l'enroulement secondaire (2b) du transformateur (2),
- un élément de commutation (5) configuré pour permettre l'activation et la désactivation d'un courant électrique dans l'enroulement primaire (2a) du transformateur (2), **caractérisé en ce que** :
- le transformateur (2) est un transformateur plan,
- des éléments de circuit de commutation flyback (6) sont configurés pour envoyer, en réponse à un signal de commande (17), une impulsion électrique d'activation en :
- commandant l'activation de l'élément de commutation (5), pour établir un courant primaire dans l'enroulement primaire (2a), et ensuite
- commandant la désactivation de l'élément de commutation (5), pour décharger l'énergie stockée dans le transformateur (2) dans l'enroulement secondaire (2b), induisant une impulsion électrique d'activation dans la grille de commande (4) pour activer le commutateur de puissance (3).

2. Circuit de commutation de puissance (1) selon la revendication 1, dans lequel le commutateur de puissance (3) est un dispositif commandé par courant.

3. Circuit de commutation de puissance (1) selon la revendication 2, dans lequel le commutateur de puissance (3) comprend l'un quelconque : d'un thyristor, d'un triac et d'un transistor BJT.

4. Circuit de commutation de puissance (1) selon la revendication 1, dans lequel le commutateur de puissance (3) est un dispositif commandé par tension.

5. Circuit de commutation de puissance (1) selon la revendication 4, dans lequel le commutateur de puissance (3) comprend l'un quelconque d'un transistor MOSFET, d'un transistor IGBT et d'un transistor JFET.

6. Circuit de commutation de puissance (1) selon la revendication 4 ou 5, comprenant en outre un circuit de désactivation (11) configuré pour désactiver le commutateur de puissance (3) en déchargeant la charge de la grille de commande du commutateur de puissance (4) après un temps prédéterminé.

7. Circuit de commutation de puissance (1) selon la revendication 4 ou 5, comprenant en outre un circuit de désactivation (11) configuré pour décharger la charge de la grille de commande du commutateur de puissance (4) en réponse à un signal de désactivation, pour désactiver le commutateur de puissance (3).

8. Circuit de commutation de puissance (1) selon la revendication 7, dans lequel le circuit de désactivation (11) est configuré pour recevoir le signal de désactivation par l'intermédiaire du transformateur plan (2).

9. Circuit de commutation de puissance (1) selon la revendication 8, dans lequel le circuit de désactivation (11) est configuré pour recevoir le signal de désactivation en tant que l'une quelconque :
- d'une impulsion électrique d'une durée différente de celle d'une impulsion électrique d'activation, ou
- de multiples impulsions électriques consécutives, ayant chacune une durée différente de celle d'une impulsion électrique d'activation, ou
- d'une impulsion électrique avec une polarité inversée comparée à une impulsion électrique d'activation.

10. Circuit de commutation de puissance (1) selon la revendication 7, dans lequel le circuit de désactivation (11) est configuré pour recevoir le signal de désactivation par l'intermédiaire d'un deuxième transformateur plan (505).

11. Circuit de commutation de puissance (1) selon l'une quelconque des revendications 1 à 10, dans lequel les éléments de circuit de commutation flyback (6) sont conçus pour envoyer de manière répétée des impulsions électriques d'activation de rafraîchissement.

12. Circuit de commutation de puissance (1) selon l'une quelconque des revendications 1 à 11, dans lequel les enroulements de l'un quelconque des transformateurs plans (2 ; 505) sont situés sur différentes couches internes d'une carte de circuit imprimé multicouche (20), chaque enroulement étant connecté par un trou d'interconnexion traversant (21, 22) qui est situé à l'intérieur des enroulements du transformateur plan (2 ; 505) et à proximité de la périphérie intérieure desdits enroulements.

13. Circuit de commutation de puissance (1) selon l'une quelconque des revendications 1 à 12, dans lequel l'un quelconque des transformateurs plans (2 ; 505) est un transformateur sans noyau ou comprend un noyau ferromagnétique.

14. Machine ou dispositif comprenant un circuit de commutation de puissance (1) selon l'une quelconque des revendications précédentes.

15. Procédé pour commander une grille de commande d'un commutateur de puissance, **caractérisé en ce qu'**il comprend :
- l'utilisation d'un transformateur plan dans un mode flyback en :
- stockant l'énergie, nécessaire pour activer le commutateur de puissance, en tant que champ magnétique dans le transformateur en établissant un courant primaire dans un enroulement primaire du transformateur plan,
- désactivant le courant primaire, déchargeant de ce fait l'énergie stockée dans le transformateur dans un enroulement secondaire du transformateur, et
- alimentant la grille du commutateur de puissance avec l'énergie déchargée dans l'enroulement secondaire, moyennant quoi la grille est activée.
